# EUROPÄISCHE PATENTSCHRIFT

(11) **EP 4 523 271 B1**
(45) Veröffentlichungstag und Bekanntmachung des Hinweises auf die Patenterteilung: **09.12.2026**
(21) Anmeldenummer: 23772086.7
(22) Anmeldetag: 22.08.2023
(51) Int. Cl.: H01M 8/04298, G01R 31/40, H01M 8/04537, H01M 8/04992

(54) **DIAGNOSEVERFAHREN UND DIAGNOSESYSTEM ZUM DIAGNOSTIZIEREN EINER BRENNSTOFFZELLE**
DIAGNOSIS METHOD AND DIAGNOSIS SYSTEM, FOR DIAGNOSING A FUEL CELL
PROCÉDÉ ET SYSTÈME DE DIAGNOSE POUR PILE À COMBUSTIBLE

(30) Priorität: 23.08.2022 AT 506452022
(43) Veröffentlichungstag der Anmeldung: 19.03.2025
(73) Patentinhaber: AVL List GmbH, 8020 Graz (AT)
(72) Erfinder: BRUHN, Tanner, 8020 Graz (AT); ALLOUCHERY, Laurent, 8047 Hart bei Graz (AT)
(86) Internationale Anmeldenummer: PCT/AT2023/060284
(87) Internationale Veröffentlichungsnummer: WO 2024/040278

(56) Entgegenhaltungen:
- DE-A1- 102017 128 901
- KRAVOS ANDRAZ ET AL: "Thermodynamically consistent reduced dimensionality electrochemical model for proton exchange membrane fuel cell performance modelling and control", JOURNAL OF POWER SOURCES ELSEVIER B.V, AMSTERDAM, NL, vol. 454, 6 March 2020 (2020-03-06), XP086095339, ISSN: 0378-7753, [retrieved on 20200306], DOI: 10.1016/J.JPOWSOUR.2020.227930
- ONANENA R ET AL: "Fuel cells static and dynamic characterizations as tools for the estimation of their ageing time", INTERNATIONAL JOURNAL OF HYDROGEN ENERGY, ELSEVIER, AMSTERDAM, NL, vol. 36, no. 2, 22 October 2010 (2010-10-22), pages 1730 - 1739, XP028132965, ISSN: 0360-3199, [retrieved on 20101130], DOI: 10.1016/J.IJHYDENE.2010.10.064
- WU ET AL: "Diagnostic tools in PEM fuel cell research: Part I Electrochemical techniques", INTERNATIONAL JOURNAL OF HYDROGEN ENERGY, ELSEVIER, AMSTERDAM, NL, vol. 33, no. 6, 5 March 2008 (2008-03-05), pages 1735 - 1746, XP022541986, ISSN: 0360-3199, DOI: 10.1016/J.IJHYDENE.2008.01.013

## Beschreibung

Die vorliegende Erfindung betrifft ein Diagnoseverfahren sowie ein Diagnosesystem zum Diagnostizieren zumindest einer Brennstoffzelle eines Brennstoffzellensystems sowie ein mit dem Diagnoseverfahren assoziiertes Computerprogrammprodukt.

Die Polarisationskurve ist das Ergebnis einer Messung, mit dem verschiedene Eigenschaften einer Brennstoffzelle bewertet werden können. Die Polarisationskurve ist dabei eine Funktion des Brennstoffzellendesigns (Katalysator, Membran, usw.), der Betriebsbedingungen (relative Feuchtigkeit, Temperatur, Druck, usw.) und der Alterung der Brennstoffzellkomponenten. Die Messung wird auf dem Prüfstand der Brennstoffzelle eines Brennstoffzellensystems durchgeführt, normalerweise unter konstanter Temperatur und definierten Betriebsbedingungen.

Um diagnostischer Parameter der Brennstoffzelle aus ihrer zugehörigen Polarisationskurve zu ermitteln, wird im Stand der Technik ein Polarisationsmodell genutzt. Ein solche Polarisationsmodell wird auf die Polarisationskurve appliziert, sodass aus dem Polarisationsmodell die gesuchten diagnostischen Parameter extrahiert werden. Die extrahierten diagnostischen Parameter können verwendet werden, um Schlussfolgerungen in Bezug auf die Brennstoffzelle zu ziehen, beispielsweise in Bezug auf ihre Degradation.

Problematisch an dem bekannten Diagnoseverfahren ist, dass sein Ergebnis vom genutzten Polarisationsmodell abhängt. Möglicherweise können nicht alle gewünschten diagnostischen Parameter mit dem genutzten Polarisationsmodelle extrahiert werden. Auch ist es möglich, dass ein Polarisationsmodell inakkurate diagnostische Parameter liefert.

Weitere Diagnoseverfahren sind beispielsweise aus der ONANENA R ET AL: "Fuel cells static and dynamic characterizations as tools for the estimation of their ageing time", INTERNATIONAL JOURNAL OF HYDROGEN ENERGY, ELSEVIER, AM-STERDAM, NL, Bd. 36, Nr. 2, 22. Oktober 2010 (2010-10-22), Seiten 1730-1739, XP028132965, ISSN: 0360-3199, DOI: 10.1016/J.IJHYDENE.2010.10.064 bekannt.

Es ist Aufgabe der vorliegenden Erfindung, die vorstehenden Probleme zumindest teilweise zu beheben. Insbesondere ist es Aufgabe der vorliegenden Erfindung, ein verbessertes Diagnoseverfahren zum Diagnostizieren einer Brennstoffzelle bereitzustellen, welches möglichst verlässliche Ergebnisse liefert.

Die voranstehende Aufgabe wird gelöst durch ein Diagnoseverfahren mit den Merkmalen des Anspruchs 1, ein Computerprogrammprodukt mit den Merkmalen des Anspruchs 90 sowie ein Diagnosesystem mit den Merkmalen des Anspruchs 10. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Diagnoseverfahren beschrieben sind, selbstverständlich auch im Zusammenhang mit dem erfindungsgemäßen Diagnosesystem sowie dem erfindungsgemäßen Computerprogrammprodukt und jeweils umgekehrt, sodass bzgl. der Offenbarung zu den einzelnen Erfindungsaspekten stets wechselseitig Bezug genommen wird oder werden kann.

Erfindungsgemäß ist ein Diagnoseverfahren zum Diagnostizieren zumindest einer Brennstoffzelle eines Brennstoffzellensystems vorgesehen, wobei das Diagnoseverfahren die folgenden Schritte aufweist:
- Bereitstellen von zumindest zwei unterschiedlichen Polarisationsmodellen zum Extrahieren eines diagnostischen Brennstoffzellen-Parametersatzes aus einer Polarisationskurve zumindest einer Brennstoffzelle,
- Erfassen von zumindest einer Polarisationskurve aus zumindest einer Messung zumindest einer Brennstoffzelle,
- Applizieren von zumindest zwei der zuvor erfassten unterschiedlichen Polarisationsmodelle auf die zumindest eine Polarisationskurve der zumindest einen Brennstoffzelle, und
- Extrahieren eines diagnostischen Brennstoffzellen-Parametersatzes aus der zumindest einen Polarisationskurve der zumindest einen Brennstoffzelle für jedes der applizierten Polarisationsmodelle, wobei die bereitgestellten Polarisationsmodelle mit verfügbaren Eingabedaten abgeglichen werden und diejenigen ausgewählten Polarisationsmodelle auf die zumindest eine Polarisationskurve appliziert werden, welche keine weiteren Eingabedaten als die verfügbaren Eingabedaten benötigen.

Das erfindungsgemäße Diagnoseverfahren nutzt damit wenigstens zwei unterschiedliche Polarisationsmodelle. Wie beschrieben, werden diese Polarisationsmodelle zum Extrahieren eines diagnostischen Brennstoffzellen-Parametersatzes aus jeweiligen Polarisationskurven einer oder mehrerer Brennstoffzellen verwendet. Derartige diagnostische Brennstoffzellen-Parametersätze können auch Polarisationsverluste als Brennstoffzellen-Parameter umfassen. Es kann sich dabei beispielsweise um Verluste aufgrund der Membrandurchlässigkeit, Aktivierungsverluste aufgrund der langsamen Kathodenreaktion (Reaktionskinetik), Verluste aufgrund des ohmschen Widerstands (elektrischer Widerstand des Elektrolyten, der Katalysatorschicht, der Gasdiffusionsschicht, der Bipolarplatten, der Schnittstellenkontakte und der Klemmenverbindungen) und Konzentrationsverluste (Lieferung von Produkten an die Reaktionsstellen, begrenzt durch die Fluiddynamik auf der Makro- und Mikroebene (Konvektion und Diffusion)) handeln. Derartige Polarisationsmodelle können beispielsweise durch einen oder mehrere mathematische Zusammenhänge, insbesondere Funktionen gegeben sein. Beispielsweise kann ein Polarisationsmodell durch eine Funktion der Zellspannung in Abhängigkeit verschiedener Eingabeparameter gegeben sein, wobei die Eingabeparameter beispielsweise Betriebsparameter, Betriebsbedingungen usw. sein können. Beispiele möglicher Polarisationsmodelle sind beispielsweise die von Chamberline-Kim und Larminie-Dicks.

Dadurch, dass unterschiedliche Polarisationsmodelle auf eine oder mehrere Polarisationskurven von einer oder mehreren Brennstoffzellen appliziert werden, wird nicht nur ein diagnostischer Brennstoffzellen-Parametersatz extrahiert und somit erhalten, sondern es werden für jedes der applizierten Polarisationsmodelle diagnostische Brennstoffzellen-Parametersätze erhalten. Diese diagnostischen Brennstoffzellen-Parametersätze stellen vorliegend die Diagnose der zumindest einen Brennstoffzelle dar, weil sie mit den darin enthaltenen Brennstoffzellen-Parametern Kenndaten darstellen, die einen Zustand oder Status der Brennstoffzelle, beispielsweise hinsichtlich Degradation, erkennen lassen. Allerdings können auch weitere Diagnoseschritte, beispielsweise eine Schätzung der Degradation, folgen. Dadurch, dass nun erfindungsgemäß wenigstens zwei diagnostische Brennstoffzellen-Parametersätze für unterschiedliche Polarisationsmodelle vorliegen, liegen bessere Diagnoseergebnisse vor, weil die Ergebnisse nicht von einem einzigen Polarisationsmodell abhängig sind, welches möglicherweise sonst nur eine ungenaue Diagnose stellt. Insbesondere durch einen Vergleich der diagnostischen Brennstoffzellen-Parametersätze miteinander, wie später näher beschrieben wird, lassen sich akkuratere Diagnoseergebnisse erzielen.

Das Diagnoseverfahren kann grundsätzlich zum Diagnostizieren einer oder mehrerer Brennstoffzellen, insbesondere auch eines oder mehrerer ganzer, insbesondere miteinander verschalteter, Brennstoffzellenstapel oder ganzer Brennstoffzellensysteme eingesetzt werden. Dabei kann je eine Polarisationskurve je Brennstoffzelle oder je Brennstoffzellenstapel oder je Brennstoffzellensystem erfasst werden.

Die Messung, aus der heraus die Polarisationskurve erfasst wird, kann insbesondere auf einem Prüfstand der zumindest einen Brennstoffzelle des Brennstoffzellensystems durchgeführt werden, vorzugsweise unter konstanter Temperatur und definierten Betriebsbedingungen. Die Messergebnisse der Messung können bei Durchführung des Diagnoseverfahrens bereits vorliegen, sodass hieraus nur noch die Polarisationskurve erfasst zu werden braucht. Die Messung kann aber auch im Rahmen des Diagnoseverfahrens durchgeführt werden, wie später näher erläutert wird.

Es ist nicht notwendig, sämtliche Verfahrensschritte des erfindungsgemäßen Verfahrens in der durch ihre Auflistung angegebenen Reihenfolge auszuführen. Stattdessen können einzelne Verfahrensschritte auch in anderer als dieser Reihenfolge oder simultan ausgeführt werden. Insbesondere können einzelne oder alle Verfahrensschritte auch wiederholt werden, insbesondere kontinuierlich durchgeführt werden. So können die diagnostischen Brennstoffzellen-Parametersätze laufend extrahiert werden und insbesondere auch ausgegeben werden. Dadurch kann, insbesondere bei einer live-Messung, bei der die Polarisationskurve kontinuierlich erfasst und darauf die Polarisationsmodelle appliziert werden, eine live-Überwachung des Diagnoseverfahrens erfolgen, wie später auch näher erläutert wird.

Wie vorstehend erwähnt worden ist, kann als ein weiterer Schritt im Diagnoseverfahren vorgesehen sein, dass wenigstens einer oder alle der extrahierten diagnostischen Brennstoffzellen-Parametersätze ausgegeben werden. Welche von den extrahierten diagnostischen Brennstoffzellen-Parametern ausgegeben werden, kann ggf. durch eine optionale Selektion, insbesondere anhand eines Verwerfens einzelner diagnostischer Brennstoffzellen-Parameter, festgestellt werden, wie später näher beispielhaft erläutert wird.

Es kann vorgesehen sein, dass das Diagnoseverfahren ferner die folgenden Schritte umfasst:
- Festlegen von Brennstoffzellen-Parametern für den zu extrahierenden diagnostischen Brennstoffzellen-Parametersatz, und
- Auswählen von zumindest zwei der bereitgestellten Polarisationsmodelle anhand der festgelegten Brennstoffzellen-Parameter in dem zu extrahierenden diagnostischen Brennstoffzellen-Parametersatz,
wobei, insbesondere nur, die ausgewählten Polarisationsmodelle auf die zumindest eine Polarisationskurve appliziert werden. Dadurch kann sichergestellt werden, dass von den bereitgestellten Polarisationsmodelle nur diejenigen zur Applikation auf die Polarisationskurve ausgewählt werden, die zuvor festgelegte Brennstoffzellen-Parameter ausgeben. Es werden also solche Polarisationsmodelle nicht berücksichtigt, welche diagnostische Brennstoffzellen-Parametersätze liefern, die die festgelegten und damit gewünschten Brennstoffzellen-Parameter nicht hergeben. Wenn beispielsweise eine Degradationsschätzung der zumindest einen Brennstoffzelle erfolgen soll, können dafür benötigte Brennstoffzellen-Parameter vorher festgelegt werden. Polarisationsmodelle, welche diese nicht in ihren diagnostischen Brennstoffzellen-Parametersätzen liefern, können dann verworfen werden. Dadurch kann eine intelligente Selektion von Polarisationsmodellen aus einer Vielzahl von bereitgestellten Polarisationsmodellen, beispielsweise in einer Datenbank, durchgeführt werden, um Rechenressourcen für ein entsprechendes Diagnosesystem, welches das Diagnoseverfahren ausführt, einzusparen und eine schnellere Diagnose zu erlauben.

Es ist erfindungsgemäß vorgesehen, dass das Diagnoseverfahren ferner umfasst, dass die bereitgestellten Polarisationsmodelle mit verfügbaren Eingabedaten abgeglichen werden und diejenigen ausgewählten Polarisationsmodelle auf die zumindest eine Polarisationskurve appliziert werden, welche, insbesondere keine weiteren Eingabedaten als, die verfügbaren Eingabedaten benötigen. Eingabedaten können beispielsweise Spannung und/oder Strom an den Brennstoffzellen, aber auch Betriebsbedingungen wie Druck, Temperatur, relative Feuchtigkeit usw. und/oder Brennstoffzellen-Daten wie Pt-Beladung, Membrandicke, usw. sein. So kann sichergestellt werden, dass nur solche Polarisationsmodelle auf die zumindest eine Polarisationskurve appliziert werden, welche anhand der erfassten zumindest einen Polarisationskurve auch eine Diagnose erlauben.

Ferner ist möglich, dass die Anpassungsgüte jedes Polarisationsmodells für die zumindest eine Polarisationskurve bestimmt wird und extrahierte diagnostische Brennstoffzellen-Parametersätze verworfen werden, die eine vorbestimmte Mindest-Anpassungsgüte unterschreiten. Die Mindest-Anpassungsgüte kann entsprechend vorbestimmt sein, um die Zuverlässigkeit der diagnostischen Brennstoffzellen-Parametersätze zu erhöhen. So kann sichergestellt werden, dass nur solche diagnostischen Brennstoffzellen-Parametersätze der weiteren Verwendung, insbesondere einer Ausgabe und/oder Schätzung der Degradation der zumindest einen Brennstoffzelle zugeführt werden, die auch hinreichend zuverlässig sind.

Ferner kann vorgesehen sein, dass die extrahierten diagnostischen Brennstoffzellen-Parametersätze unterschiedlicher Polarisationsmodelle miteinander verglichen werden. Dies erlaubt es, die diagnostischen Brennstoffzellen-Parametersätze gegeneinander zu prüfen und die diagnostischen Ergebnisse zu untermauern, soweit sie im Wesentlichen einander entsprechen. Dies erlaubt es also ebenfalls, die Zuverlässigkeit des Diagnoseverfahrens bzw. der daraus gewonnenen Ergebnisse zu erhöhen.

Hierbei kann ganz besonders vorgesehen sein, dass auf Basis des Vergleichs ein gemeinsamer diagnostischer Brennstoffzellen-Parametersatz für die zumindest eine Brennstoffzelle gebildet wird. So können die jeweils am zuverlässigsten erachteten Brennstoffzellen-Parameter aus den jeweiligen diagnostischen Brennstoffzellen-Parametersätzen gewonnen werden und zu einem gemeinsamen diagnostischen Brennstoffzellen-Parametersatz zusammengefügt werden. Es kann aber auch beispielsweise jeweils ein gemeinsamer Wert für die jeweiligen Brennstoffzellen-Parameter aus den unterschiedlichen diagnostischen Brennstoffzellen-Parametersätzen gebildet werden, beispielsweise ein Mittelwert, ein gewichteter Mittelwert, ein Median oder ähnlich, wobei diese gemeinsamen Werte dann den gemeinsamen diagnostischen Brennstoffzellen-Parametersatz bilden.

Möglich ist ferner, dass eine Plausibilitätsprüfung der extrahierten diagnostischen Brennstoffzellen-Parametersätze durchgeführt wird. Dabei kann beispielsweise überprüft werden, ob die Brennstoffzellen-Parameter eines diagnostischen Brennstoffzellen-Parametersatzes den anderen diagnostischen Brennstoffzellen-Parametersätzen widersprechen oder außerhalb von vordefinierten Wertebereichen liegen, sodass daraus geschlossen werden kann, dass diese extrahierten diagnostischen Brennstoffzellen-Parametersätze als nicht plausibel verworfen werden können. Auch dies erhöht die Zuverlässigkeit des Diagnoseverfahrens.

Auch ist möglich, dass Brennstoffzellen-Parameter von extrahierten Brennstoffzellen-Parametersätzen mit Degradations- und/oder Fehlerparametern aus einer Datenbank verglichen werden. Die Datenbank kann beispielsweise mit Werten früherer Diagnoseergebnisse und/oder Werten aus einem oder mehreren Simulationsmodellen bestückt sein. Dadurch ist es möglich, die Brennstoffzellen-Parameter mit einer Datenbank von Fehler- und/oder Degradations-Fingerabdrücken abzugleichen, um einen Fehlerfall, eine Beschädigung und/oder eine Degradation der zumindest einen Brennstoffzelle abzuschätzen. Grundsätzlich ist es auch vorteilhaft, wenn die Brennstoffzellenparameter selbst entwickelt werden, beispielswiese über eine Polarisationskurve mit einem ersten Datensatz und anschließend über den gleichen Prozess mit einer Polarisationskurve mit einem zweiten Datensatz. Folglich entwickelt sich dabei der Parameter insbesondere über die Zeit.

Es ist weiter vorgesehen, dass anhand von Brennstoffzellen-Parametern der extrahierten Brennstoffzellen-Parametersätze die Degradation der zumindest einen Brennstoffzelle geschätzt wird. Diese Verwendung der extrahierten Brennstoffzellen-Parametersätze ist besonders vorteilhaft, weil gleich mehrere extrahierte Brennstoffzellen-Parametersätze bereitstehen und/oder nur solche noch verwendet werden, die nicht zuvor verworfen worden sind. Durch die Vielzahl von Parameterinformationen kann eine sehr genaue und verlässliche Schätzung der Degradation der zumindest einen Brennstoffzelle erfolgen.

Möglich ist ferner, dass die Messung der zumindest einen Brennstoffzelle als Teil des Diagnoseverfahrens durchlaufen wird. Insbesondere kann die Messung zumindest zeitweise parallel zum Applikations- und/oder Extraktionsschritt des Diagnoseverfahrens durchlaufen werden. So kann die Polarisationskurve anhand der Messung laufend aktualisiert erfasst und appliziert werden, um ein live-Diagnoseverfahren, bei dem die zumindest eine Brennstoffzelle in einem Prüfstand eingebunden sein kann, bereitzustellen.

Möglichst ist hierbei, dass die Messung der zumindest einen Brennstoffzelle von zumindest einem der extrahierten diagnostischen Brennstoffzellen-Parametersätzen aktiv beeinflusst wird. Mit anderen Worten erfolgt eine Rückkopplung ans Messverfahren auf Basis zumindest eines der extrahierten diagnostischen Brennstoffzellen-Parametersätze. Durch die Änderung von Messparametern im Messverfahren, insbesondere auf dem Prüfstand der zumindest einen Brennstoffzelle, kann entsprechend Einfluss auf das Diagnoseergebnis genommen werden.

Es kann auch vorteilhaft vorgesehen sein, dass die extrahierten diagnostische Brennstoffzellen-Parametersätze der mindestens einen Brennstoffzelle durch eine Anpassungsgüte eines jeden Polarisationsmodells aktiv beeinflusst werden. Es kann also sein, dass die Brennstoffzelle aktiv von den extrahierten diagnostische Brennstoffzellen-Parametersätze beeinflusst wird.

Ebenfalls Gegenstand der vorliegenden Erfindung ist ein Computerprogrammprodukt, umfassend Befehle, die bei der Ausführung des Programms durch einen Computer diesen veranlassen, das erfindungsgemäße Diagnoseverfahren auszuführen.

Damit bringt ein erfindungsgemäßes Computerprogrammprodukt die gleichen Vorteile mit sich, wie sie ausführlich mit Bezug auf das erfindungsgemäße Diagnoseverfahren erläutert worden sind.

Das Computerprogrammprodukt kann dabei ein Computerprogramm an sich oder ein Produkt, etwa ein computerlesbarer Datenspeicher, sein, auf dem ein Computerprogramm zur Ausführung des erfindungsgemäßen Verfahrens gespeichert sein kann. Als Computerprogrammprodukt kann im Rahmen der Erfindung vorteilhaft auch eine analoge Platine und ein Bildschirm wie beispielsweise ein Oszilloskop sein.

Ebenfalls Gegenstand der vorliegenden Erfindung ist ein Diagnosesystem zum Diagnostizieren zumindest einer Brennstoffzelle eines Brennstoffzellensystems, wobei das Diagnosesystem die folgenden Module aufweist:
- ein Bereitstellungsmodul zum Bereitstellen von zumindest zwei unterschiedlichen Polarisationsmodellen zum Extrahieren eines diagnostischen Parametersatzes aus einer Polarisationskurve zumindest einer Brennstoffzelle,
- ein Erfassungsmodul zum Erfassen von zumindest einer Polarisationskurve aus zumindest einer Messung der zumindest einen Brennstoffzelle,
- ein Applikationsmodul zum Applizieren von zumindest zwei der zuvor erfassten unterschiedlichen Polarisationsmodelle auf die zumindest eine Polarisationskurve der zumindest einen Brennstoffzelle, und
- ein Extraktionsmodul zum Extrahieren eines diagnostischen Brennstoffzellen-Parametersatzes aus der zumindest einen Polarisationskurve der zumindest einen Brennstoffzelle für jedes der applizierten Polarisationsmodelle.

Damit bringt ein erfindungsgemäßes Diagnosesystem die gleichen Vorteile mit sich, wie sie ausführlich mit Bezug auf das erfindungsgemäße Diagnoseverfahren erläutert worden sind.

Insbesondere kann das Diagnosesystem zum Ausführen des erfindungsgemäßen Diagnoseverfahrens eingerichtet bzw. ausgebildet sein.

Die Module des Diagnosesystems können dabei beispielsweise jeweils durch einen separaten Computerprogrammcode oder gemeinsam durch einen gemeinsamen Computerprogrammcode und/oder durch separate oder gemeinsame Funktionseinheiten eines Computers implementiert sein. Möglich ist auch, dass einzelne Module in einem gemeinsamen Modul implementiert sind. Das Diagnosesystem kann insbesondere einen oder mehrere Computer umfassen oder durch den einen oder mehrere Computer gebildet sein, welcher oder welche die einzelnen Module aufweisen können.

Die genannten Module können auch zur Ausführung der weiteren, hierin beschriebenen Schritte des Diagnoseverfahrens eingerichtet sein. Es können aber auch jeweils zusätzliche Module für jeden der einzelnen Schritte vorgesehen sein, die in entsprechender Benennung des jeweiligen Schritts voneinander unterschieden werden können.

Weitere Vorteile, Merkmale und Einzelheiten der Erfindung ergeben sich aus der nachfolgenden Beschreibung, in der unter Bezugnahme auf die Zeichnungen Ausführungsbeispiele im Einzelnen beschreiben sind.

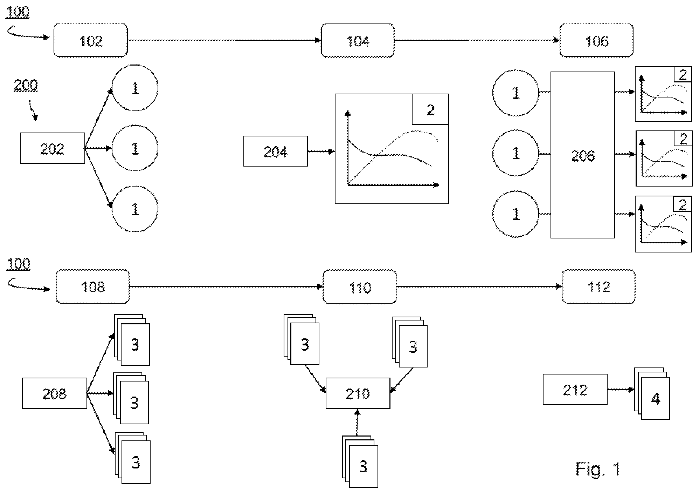

Figur 1 zeigt dabei eine schematische Ansicht eines Ausführungsbeispiels eines erfindungsgemäßen Diagnoseverfahrens 100 und Diagnosesystems 200.

**In** einem ersten Verfahrensschritt erfolgt ein Bereitstellen 102 von vorliegend rein beispielhaft drei unterschiedlichen Polarisationsmodellen 1. Diese können beispielsweise durch einen oder mehrere mathematische Zusammenhänge, insbesondere Funktionen, gegeben sein, welche sich voneinander unterscheiden. Das Bereitstellen 102 erfolgt durch ein Bereitstellungsmodul 202 des Diagnosesystems 200.

**In** einem anschließenden Verfahrensschritt erfolgt ein Erfassen 104 einer Polarisationskurve 2 aus einer Messung (eines Betriebs) einer oder mehrerer Brennstoffzellen auf einem entsprechenden Prüfstand des Brennstoffzellensystems dieser Brennstoffzellen. Beispielhaft soll hier von einem Brennstoffzellenstapel ausgegangen wird, der zuvor gemessen worden sein kann oder im Rahmen des Diagnoseverfahrens 100 gemessen werden kann. Die aus der Messung erfasste Polarisationskurve 2 gibt verschiedenen Eigenschaften des Brennstoffzellenstapels an. Das Erfassen 104 kann durch ein Erfassungsmodul 204 des Diagnosesystems 200 ausgeführt werden.

In einem weiteren Verfahrensschritt erfolgt ein Applizieren 106 der unterschiedlichen Polarisationsmodelle 1 mittels eines Applikationsmoduls 206 des Diagnosesystems 200 auf die Polarisationskurve des Brennstoffzellenstapels. Dadurch erfolgt in einem folgenden Verfahrensschritt ein Extrahieren 108 durch ein Extraktionsmodul 208 eines diagnostischen Brennstoffzellen-Parametersatzes 3 aus der Polarisationskurve 2 des Brennstoffzellenstapels für jedes darauf applizierte Polarisationsmodell 1.

Dadurch liegen nun drei extrahierte diagnostische Brennstoffzellen-Parametersätze 3 vor, die jeweils auf unterschiedlichen Polarisationsmodellen 1 beruhen, die zu Beginn bereitgestellt worden sind. Diese diagnostischen Brennstoffzellen-Parametersätze 3 können nun unmittelbar durch das Diagnoseverfahren 100 und das Diagnosesystem 200 ausgegeben werden, was nicht gezeigt ist, und/oder weitere Verfahrensschritte durchlaufen.

Beispielhaft ist in der Fig. 1 gezeigt, wie in einem folgenden Verfahrensschritt ein Vergleichen 110 durch ein Vergleichsmodul 210 der diagnostischen Brennstoffzellen-Parametersätze 3 miteinander erfolgt. Ferner ist beispielhaft in der Fig. 1 gezeigt, wie in einem nachfolgenden Verfahrensschritt ein Bilden 112 eines Bildungsmoduls 212 eines gemeinsamen diagnostischen Brennstoffzellen-Parametersatzes 4 auf Basis des vorherigen Vergleichs erfolgt. Es wird also für alle einzelnen diagnostischen Brennstoffzellen-Parametersätze 3 ein gemeinsamer diagnostischer Brennstoffzellen-Parametersatz 4 gebildet, der möglichst akkurate Brennstoffzellen-Parameter angibt, welche den Brennstoffzellenstapel charakterisieren. Diese Brennstoffzellen-Parameter können ausgegeben werden oder, in einem weiteren, nicht gezeigten Verfahrensschritt zur Schätzung der Degradation des Brennstoffzellenstapels verwendet werden.

Zusätzlich oder alternativ kann das Diagnoseverfahren 100 weitere, hier nicht gezeigte Verfahrensschritte umfassen, wie beispielsweise ein Festlegen von zu extrahierenden Brennstoffzellen-Parametern, einen Abgleich mit Eingabedaten, eine Bestimmung einer Anpassungsgüte, eine Plausibilitätsprüfung usw., wie sie insbesondere hierin zuvor beschrieben worden sind.

Die voranstehenden Erläuterungen der Ausführungsformen beschreiben die vorliegende Erfindung ausschließlich im Rahmen von Beispielen.

### Bezugszeichenliste

- 100: Diagnoseverfahren
- 102: Bereitstellen
- 104: Erfassen
- 106: Applizieren
- 108: Extrahieren
- 110: Vergleichen
- 112: Bilden
- 200: Diagnosesystem
- 202: Bereitstellungsmodul
- 204: Erfassungsmodul
- 206: Applikationsmodul
- 208: Extraktionsmodul
- 210: Vergleichsmodul
- 212: Bildungsmodul

## Patentansprüche

1. Diagnoseverfahren (100) zum Diagnostizieren zumindest einer Brennstoffzelle eines Brennstoffzellensystems, wobei das Diagnoseverfahren (100) folgende Schritte aufweist:
- Bereitstellen (102) von zumindest zwei unterschiedlichen Polarisationsmodellen (1) zum Extrahieren eines diagnostischen Brennstoffzellen-Parametersatzes (3) aus einer Polarisationskurve (2) zumindest einer Brennstoffzelle,
- Erfassen (104) von zumindest einer Polarisationskurve (2) aus zumindest einer Messung zumindest einer Brennstoffzelle,
- Applizieren (106) von zumindest zwei der zuvor erfassten unterschiedlichen Polarisationsmodelle (1) auf die zumindest eine Polarisationskurve (2) der zumindest einen Brennstoffzelle, und
- Extrahieren (108) eines diagnostischen Brennstoffzellen-Parametersatzes (3) aus der zumindest einen Polarisationskurve (2) der zumindest einen Brennstoffzelle für jedes der applizierten Polarisationsmodelle (1),
- **dadurch gekennzeichnet, dass** das Diagnoseverfahren (100) ferner umfasst, dass die bereitgestellten Polarisationsmodelle (1) mit verfügbaren Eingabedaten abgeglichen werden und diejenigen ausgewählten Polarisationsmodelle (1) auf die zumindest eine Polarisationskurve (2) appliziert werden, welche keine weiteren Eingabedaten als die verfügbaren Eingabedaten benötigen, wobei anhand von Brennstoffzellen-Parametern der extrahierten Brennstoffzellen-Parametersätze (3) die Degradation der zumindest einen Brennstoffzelle geschätzt wird.

2. Diagnoseverfahren (100) nach Anspruch 1, **dadurch gekennzeichnet, dass** das Diagnoseverfahren (100) ferner die folgenden Schritte umfasst:
- Festlegen von Brennstoffzellen-Parametern für den zu extrahierenden diagnostischen Brennstoffzellen-Parametersatz (3), und
- Auswählen von zumindest zwei der bereitgestellten Polarisationsmodelle (1) anhand der festgelegten Brennstoffzellen-Parameter in dem zu extrahierenden diagnostischen Brennstoffzellen-Parametersatz (3),
wobei die ausgewählten Polarisationsmodelle (1) auf die zumindest eine Polarisationskurve (2) appliziert werden.

3. Diagnoseverfahren (100) nach einem der voranstehenden Ansprüche, **dadurch gekennzeichnet, dass** die Anpassungsgüte jedes Polarisationsmodells (1) für die zumindest eine Polarisationskurve (2) bestimmt wird und extrahierte diagnostische Brennstoffzellen-Parametersätze (3) verworfen werden, die eine vorbestimmte Mindest-Anpassungsgüte unterschreiten.

4. Diagnoseverfahren (100) nach einem der voranstehenden Ansprüche, **dadurch gekennzeichnet, dass** die extrahierten diagnostischen Brennstoffzellen-Parametersätze (3) unterschiedlicher Polarisationsmodelle (1) miteinander verglichen werden.

5. Diagnoseverfahren (100) nach Anspruch 4, **dadurch gekennzeichnet, dass** auf Basis des Vergleichs ein gemeinsamer diagnostischer Brennstoffzellen-Parametersatz (4) für die zumindest eine Brennstoffzelle gebildet wird.

6. Diagnoseverfahren (100) nach einem der voranstehenden Ansprüche, **dadurch gekennzeichnet, dass** eine Plausibilitätsprüfung der extrahierten diagnostischen Brennstoffzellen-Parametersätze (3) durchgeführt wird.

7. Diagnoseverfahren (100) nach einem der voranstehenden Ansprüche, **dadurch gekennzeichnet, dass** Brennstoffzellen-Parameter von extrahierten Brennstoffzellen-Parametersätzen (3) mit Degradations- und/oder Fehlerparametern aus einer Datenbank verglichen werden.

8. Diagnoseverfahren (100) nach einem der voranstehenden Ansprüche, **dadurch gekennzeichnet, dass** die Messung der zumindest einen Brennstoffzelle als Teil des Diagnoseverfahrens (100) durchlaufen wird.

9. Computerprogrammprodukt, umfassend Befehle, die bei der Ausführung des Programms durch einen Computer diesen veranlassen, das Diagnoseverfahren nach einem der voranstehenden Ansprüche auszuführen.

10. Diagnosesystem (200) zum Ausführen des Diagnoseverfahrens nach einem der Ansprüche 1 bis 8, wobei das Diagnosesystem (200) durch die folgenden Module **gekennzeichnet** ist:
- ein Bereitstellungsmodul (202) zum Bereitstellen von zumindest zwei unterschiedlichen Polarisationsmodellen (1) zum Extrahieren eines diagnostischen Parametersatzes (3) aus einer Polarisationskurve (2) einer Brennstoffzelle,
- ein Erfassungsmodul (204) zum Erfassen von zumindest einer Polarisationskurve (2) aus zumindest einer Messung der zumindest einen Brennstoffzelle,
- ein Applikationsmodul (206) zum Applizieren von zumindest zwei der zuvor erfassten unterschiedlichen Polarisationsmodelle (1) auf die zumindest eine Polarisationskurve (2) der zumindest einen Brennstoffzelle, und
- ein Extraktionsmodul (208) zum Extrahieren eines diagnostischen Brennstoffzellen-Parametersatzes (3) aus der zumindest einen Polarisationskurve (2) der zumindest einen Brennstoffzelle für jedes der applizierten Polarisationsmodelle (1).

## Claims

1. Diagnostic method (100) for diagnosing at least one fuel cell of a fuel cell system, wherein the diagnostic method (100) comprises the following steps:
- providing (102) at least two different polarization models (1) for extracting a diagnostic fuel cell parameter set (3) from a polarization curve (2) of at least one fuel cell,
- acquiring (104) at least one polarization curve (2) from at least one measurement of at least one fuel cell,
- applying (106) at least two of the previously acquired different polarization models (1) to the at least one polarization curve (2) of the at least one fuel cell, and
- extracting (108) a diagnostic fuel cell parameter set (3) from the at least one polarization curve (2) of the at least one fuel cell for each of the applied polarization models (1),
- **characterized in that** the diagnostic method (100) further comprises that the provided polarization models (1) are matched with available input data and those selected polarization models (1) are applied to the at least one polarization curve (2) which require no further input data than the available input data, wherein the degradation of the at least one fuel cell is estimated based on fuel cell parameters of the extracted fuel cell parameter sets (3).

2. Diagnostic method (100) according to claim 1, **characterized in that** the diagnostic method (100) further comprises the following steps:
- defining fuel cell parameters for the diagnostic fuel cell parameter set (3) to be extracted, and
- selecting at least two of the provided polarization models (1) based on the defined fuel cell parameters in the diagnostic fuel cell parameter set (3) to be extracted,
wherein the selected polarization models (1) are applied to the at least one polarization curve (2).

3. Diagnostic method (100) according to any one of the preceding claims, **characterized in that** the goodness of fit of each polarization model (1) for the at least one polarization curve (2) is determined and extracted diagnostic fuel cell parameter sets (3) are discarded which fall below a predetermined minimum goodness of fit.

4. Diagnostic method (100) according to any one of the preceding claims, **characterized in that** the extracted diagnostic fuel cell parameter sets (3) of different polarization models (1) are compared with one another.

5. Diagnostic method (100) according to claim 4, **characterized in that** on the basis of the comparison a common diagnostic fuel cell parameter set (4) for the at least one fuel cell is formed.

6. Diagnostic method (100) according to any one of the preceding claims, **characterized in that** a plausibility check of the extracted diagnostic fuel cell parameter sets (3) is carried out.

7. Diagnostic method (100) according to any one of the preceding claims, **characterized in that** fuel cell parameters of extracted fuel cell parameter sets (3) are compared with degradation and/or fault parameters from a database.

8. Diagnostic method (100) according to any one of the preceding claims, **characterized in that** the measurement of the at least one fuel cell is run through as part of the diagnostic method (100).

9. Computer program product comprising instructions which, when the program is executed by a computer, cause the computer to carry out the diagnostic method according to any one of the preceding claims.

10. Diagnostic system (200) for carrying out the diagnostic method according to any one of claims 1 to 8, wherein the diagnostic system (200) is **characterized by** the following modules:
- a provision module (202) for providing at least two different polarization models (1) for extracting a diagnostic parameter set (3) from a polarization curve (2) of a fuel cell,
- an acquisition module (204) for acquiring at least one polarization curve (2) from at least one measurement of the at least one fuel cell,
- an application module (206) for applying at least two of the previously acquired different polarization models (1) to the at least one polarization curve (2) of the at least one fuel cell, and
- an extraction module (208) for extracting a diagnostic fuel cell parameter set (3) from the at least one polarization curve (2) of the at least one fuel cell for each of the applied polarization models (1).

## Revendications

1. Procédé de diagnostic (100) pour diagnostiquer au moins une pile à combustible d'un système de pile à combustible, dans lequel le procédé de diagnostic (100) comporte les étapes suivantes :
- fourniture (102) d'au moins deux modèles de polarisation (1) différents pour extraire un jeu diagnostique de paramètres de pile à combustible (3) à partir d'une courbe de polarisation (2) d'au moins une pile à combustible,
- acquisition (104) d'au moins une courbe de polarisation (2) à partir d'au moins une mesure d'au moins une pile à combustible,
- application (106) d'au moins deux des modèles de polarisation (1) différents précédemment acquis à l'au moins une courbe de polarisation (2) de l'au moins une pile à combustible, et
- extraction (108) d'un jeu diagnostique de paramètres de pile à combustible (3) à partir de l'au moins une courbe de polarisation (2) de l'au moins une pile à combustible pour chacun des modèles de polarisation (1) appliqués,
- **caractérisé en ce que** le procédé de diagnostic (100) comporte en outre le fait que les modèles de polarisation (1) fournis sont mis en correspondance avec des données d'entrée disponibles et que les modèles de polarisation (1) sélectionnés qui ne nécessitent pas d'autres données d'entrée que les données d'entrée disponibles sont appliqués à l'au moins une courbe de polarisation (2), dans lequel la dégradation de l'au moins une pile à combustible est estimée à l'aide de paramètres de pile à combustible des jeux de paramètres de pile à combustible (3) extraits.

2. Procédé de diagnostic (100) selon la revendication 1, **caractérisé en ce que** le procédé de diagnostic (100) comporte en outre les étapes suivantes :
- définition de paramètres de pile à combustible pour le jeu diagnostique de paramètres de pile à combustible (3) à extraire, et
- sélection d'au moins deux des modèles de polarisation (1) fournis à l'aide des paramètres de pile à combustible définis dans le jeu diagnostique de paramètres de pile à combustible (3) à extraire,
dans lequel les modèles de polarisation (1) sélectionnés sont appliqués à l'au moins une courbe de polarisation (2).

3. Procédé de diagnostic (100) selon l'une des revendications précédentes, **caractérisé en ce que** la qualité d'ajustement de chaque modèle de polarisation (1) pour l'au moins une courbe de polarisation (2) est déterminée et des jeux diagnostiques de paramètres de pile à combustible (3) extraits qui sont inférieurs à une qualité d'ajustement minimale prédéterminée sont rejetés.

4. Procédé de diagnostic (100) selon l'une des revendications précédentes, **caractérisé en ce que** les jeux diagnostiques de paramètres de pile à combustible (3) extraits de modèles de polarisation (1) différents sont comparés entre eux.

5. Procédé de diagnostic (100) selon la revendication 4, **caractérisé en ce que**, sur la base de la comparaison, un jeu diagnostique commun de paramètres de pile à combustible (4) est formé pour l'au moins une pile à combustible.

6. Procédé de diagnostic (100) selon l'une des revendications précédentes, **caractérisé en ce qu'**un contrôle de plausibilité des jeux diagnostiques de paramètres de pile à combustible (3) extraits est réalisé.

7. Procédé de diagnostic (100) selon l'une des revendications précédentes, **caractérisé en ce que** des paramètres de pile à combustible de jeux de paramètres de pile à combustible (3) extraits sont comparés à des paramètres de dégradation et/ou de défaut provenant d'une base de données.

8. Procédé de diagnostic (100) selon l'une des revendications précédentes, **caractérisé en ce que** la mesure de l'au moins une pile à combustible est effectuée dans le cadre du procédé de diagnostic (100).

9. Produit programme d'ordinateur comprenant des instructions qui, lorsque le programme est exécuté par un ordinateur, conduisent celui-ci à mettre en œuvre le procédé de diagnostic selon l'une des revendications précédentes.

10. Système de diagnostic (200) pour mettre en œuvre le procédé de diagnostic selon l'une des revendications 1 à 8, dans lequel le système de diagnostic (200) est **caractérisé par** les modules suivants :
- un module de fourniture (202) pour fournir au moins deux modèles de polarisation (1) différents pour extraire un jeu diagnostique de paramètres (3) à partir d'une courbe de polarisation (2) d'une pile à combustible,
- un module d'acquisition (204) pour acquérir au moins une courbe de polarisation (2) à partir d'au moins une mesure de l'au moins une pile à combustible,
- un module d'application (206) pour appliquer au moins deux des modèles de polarisation (1) différents précédemment acquis à l'au moins une courbe de polarisation (2) de l'au moins une pile à combustible, et
- un module d'extraction (208) pour extraire un jeu diagnostique de paramètres de pile à combustible (3) à partir de l'au moins une courbe de polarisation (2) de l'au moins une pile à combustible pour chacun des modèles de polarisation (1) appliqués.
